# EUROPEAN PATENT APPLICATION

(11) **EP 4 471 375 A1**
(43) Date of publication of application: **04.12.2024**
(21) Application number: 24177019.7
(22) Date of filing: 21.05.2024
(51) Int. Cl.: G01C 19/5712, B81B 7/00, G01C 19/574, G01C 19/5747

(54) **MICROELECTROMECHANICAL GYROSCOPE WITH IMPROVED VIBRATION REJECTION**

(30) Priority: 01.06.2023 IT 202300011235
(71) Applicant: STMicroelectronics International N.V., 1228 Plan-les-Ouates, Geneva (CH)
(72) Inventor: FEDELI, Patrick, 20030 SENAGO (MI) (IT); FALORNI, Luca Giuseppe, 20812 LIMBIATE (MB) (IT); MORELLI, Federico, 20146 MILANO (IT); CARULLI, Paola, 20148 MILANO (IT)
(74) Representative: Studio Torta S.p.A.

(57) **Abstract**

A triaxial microelectromechanical gyroscope (100), provided in a die (101) of semiconductor material has a substrate (11) and a detection structure (10;10') suspended over the substrate (11). The detection structure (10;10') has a main extension in a horizontal plane (xy) and comprises: a first and second roll detection masses (R1,R2, R1',R2'); a first and second pairs of driving masses (D1,D2, D1',D2') and a first and second pairs of pitch detection masses (P1,P2, P1',P2'), arranged laterally and externally to the first, respectively second, roll detection mass in the horizontal plane (xy); and a first and a second pairs of yaw detection elements (31, 32), coupled to the pitch detection masses of the first, respectively second, pair. The detection masses or elements of each pair are capacitively coupled to stator electrodes according to a differential detection scheme, so that an angular velocity about a respective detection axis causes a detectable variation of a detection capacitance resulting from the capacitive coupling and linear vibrations or angular vibrations do not cause any variation of the detection capacitance.

## Description

### TECHNICAL FIELD

The present solution relates to a microelectromechanical gyroscope having improved vibration rejection. In particular, the following disclosure will refer to a gyroscope of a triaxial type, i.e., capable of detecting angular velocities along three orthogonal axes (typically denoted as roll, pitch and yaw axes).

### CONTEXT

As is known, current micromachining techniques allow to obtain microelectromechanical systems (MEMS) starting from layers of semiconductor material, which have been deposited (for example, a layer of polycrystalline silicon) or grown (for example, an epitaxial layer) on sacrificial layers, which are removed via chemical etching. Inertial sensors, accelerometers, and gyroscopes obtained with this technology are witnessing a growing success, for example in the automotive field, in inertial navigation, or in the field of portable devices for consumer electronics.

In particular, microelectromechanical gyroscopes are known, which are made with MEMS semiconductor technology (in what follows referred to simply as MEMS gyroscopes).

Such MEMS gyroscopes operate on the basis of the theorem of relative accelerations, exploiting Coriolis acceleration. When a rotation is applied to a mobile mass that is driven with a linear velocity at a certain angular velocity (the value of which is to be detected), the same mobile mass is subjected an apparent force, referred to as Coriolis force, which causes a displacement thereof in a direction perpendicular to the direction of the linear driving velocity and further perpendicular to the axis about which the rotation occurs. The mobile mass is supported via elastic elements that enable both the driving displacement and a detection displacement of the mass in the direction of the apparent force. According to Hooke's law, the displacement is proportional to the apparent force so that, from the detection displacement of the mobile mass, it is possible to detect the Coriolis force and the value of the angular velocity of the rotation that has generated it.

The detection displacement of the mobile mass may, for example, be detected in a capacitive way by determining, in a resonance condition, the variations of capacitance caused by the movement of mobile detection electrodes, which are fixed with respect to the mobile mass (or constituted by parts of the same mobile mass) and are coupled (for example, in a so-called parallel-plate configuration, or else in a combfingered configuration) to fixed detection electrodes.

The need is currently felt to provide a MEMS gyroscope, in particular, of a triaxial type, having a reduced occupation of area and reduced consumption levels and also enabling improved rejection of vibrations, which represent a disturbance with respect to detection of the angular velocities. Applications that have recently witnessed development and diffusion, for example in the field of virtual reality (VR) or augmented reality (AR), require in fact more demanding specifications as regards elimination of vibrations and at the same time maintenance of overall dimensions and performance comparable to those of known sensors so as to maintain full compatibility with current consumer products.

However, angular-velocity sensors commonly used, in particular, in the so-called consumer-electronics market, do not have performance characteristics specifically aimed at rejection of vibrations (in particular vibrations of an angular, nonlinear, nature, as will be discussed hereinafter).

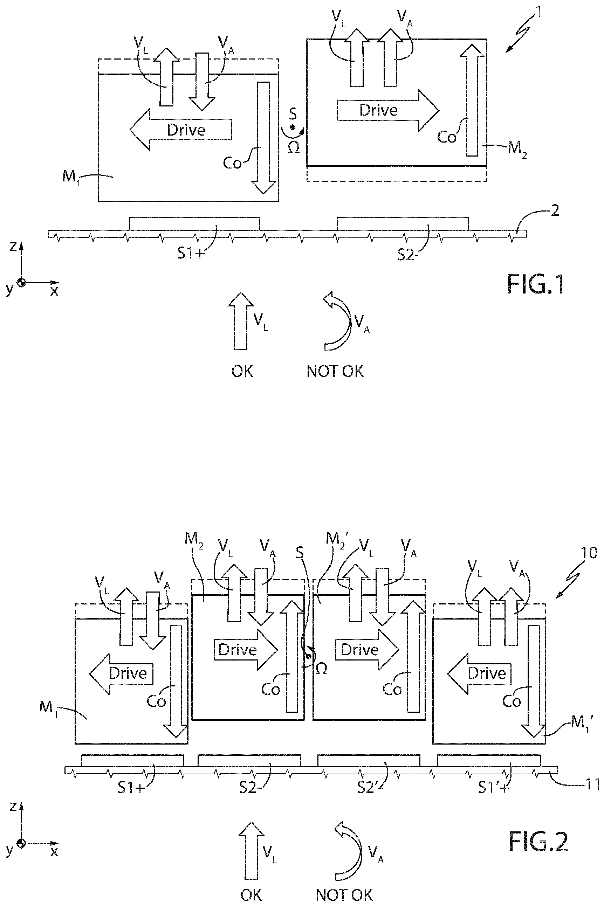

In this regard, Figure 1 shows schematically (in cross-sectional view) the architecture of a detection structure of a gyroscope of a known type, with reference by way of example to detection of an angular velocity along just one detection axis, for example a roll axis, corresponding to a first axis (in the example, y axis) of a horizontal plane xy of main extension of the same detection structure.

The detection structure, designated as a whole by 1, is symmetrical with respect to a central axis of symmetry S and comprises a pair of detection masses, formed by a first detection mass and a second detection mass, denoted, respectively, by M1, M2, arranged on opposite sides with respect to the aforesaid central axis of symmetry S, suspended elastically over a substrate 2.

On the same substrate 2, a first and a second fixed or stator electrode S1, S2 are arranged in positions facing and underlying (along a vertical axis z, orthogonal to the aforesaid horizontal plane) the aforesaid first and second detection masses M1, M2; these first and second fixed electrodes S1, S2 are fixed with respect to the substrate 2 and are capacitively coupled to the detection masses M1, M2, in a differential configuration (the stator electrodes S1, S2 thus being also arranged symmetrically with respect to the central axis of symmetry S and constituting a positive electrode '+' and a negative electrode '-', respectively, for the differential detection scheme).

The detection masses M1, M2 are driven in opposite directions (in phase opposition) with a driving movement "Drive" along a second axis (axis x) of the horizontal plane xy, orthogonal to the aforesaid first axis, with a linear oscillation movement (which thus causes them to approach to, or alternatively moving away from, the aforesaid central axis of symmetry S).

In the presence of an angular velocity, designated by Ω, acting about the aforesaid axis of symmetry, a Coriolis force is generated on the detection masses M1, M2, which causes their displacement in opposite directions along the vertical axis z (as indicated by the arrows "Co") and consequently, for example, the approach to, and respectively moving away from, the respective stator electrode S1, S2. A differential capacitive variation is thus generated, which may provide (after appropriate processing by an electronic circuit, for example of an ASIC - Application-Specific Integrated Circuit - type associated to the detection structure 1) an indication of the value of the aforesaid angular velocity Ω.

The above detection architecture enables rejection of linear accelerations of disturbance (for example, due to impact or vibrations) that act on the detection structure 1 along the aforesaid vertical axis z (as indicated by the arrow V_{L} in the aforesaid Figure 1). Such linear vibrations in fact lead to a concordant movement of the detection masses M1, M2 and consequently capacitive variations that are cancelled out by the differential detection.

Instead, it is evident that angular accelerations of disturbance (for example, once again due to vibrations or impact), denoted by V_{A}, producing an effect of rotation about the aforesaid central axis of symmetry S and thus a movement, in phase opposition, of the detection masses M1, M2 along the vertical axis z (like the movement induced by the aforesaid Coriolis force), will not be rejected in the detection structure 1.

The above angular vibrations may therefore affect detection of the angular velocity of interest, in particular, in the case where the frequency of said vibrations is close to the driving frequency of the gyroscope or to the natural frequency of spurious modes of the corresponding detection structure.

In order to solve the above problem, it has, for example, been proposed to adopt a reduced value of the gyroscope quality factor Q in order to limit detection and amplification of the spurious external vibrations.

Alternatively, it has been proposed to shift all the (operating and spurious) modes of the gyroscope beyond a given frequency band where vibrations may occur during operation of the same gyroscope.

Both solutions, however, have some drawbacks.

In particular, the value of the Q factor is important for determining the performance of the gyroscope and it is not possible to reduce it without adversely affecting such performance (for example, as regards a driving capacity).

Furthermore, the use of higher operating frequencies entails a greater stiffness of the elements of the detection structure, with consequent reduction of the sensitivity and increase in the driving voltages required to keep the masses in oscillation. Furthermore, a redesign of the electronic circuit associated with the detection structure may be required on account of the change of the system clock (connected to the operating frequency of the gyroscope).

The need is thus felt to provide a new architecture for a detection structure of a MEMS gyroscope that will have improved rejection of disturbance, in particular, linked to angular vibrations, without being affected by the above discussed drawbacks.

### SUMMARY

The object of the present solution is to solve, at least in part, the problems highlighted previously and to meet the aforesaid need.

According to the present solution, a microelectromechanical gyroscope is consequently provided, as defined in the appended claims.

### BRIEF DESCRIPTION OF THE DRAWINGS

For a better understanding of the present invention, a preferred embodiment thereof is now described, purely by way of non-limiting example and with reference to the attached drawings, wherein:
- Figure 1 is a schematic cross-sectional illustration of a portion of a detection structure of a known type of a MEMS gyroscope, with reference to a detection axis;
- Figure 2 is a schematic cross-sectional illustration of a portion of a detection structure of a MEMS gyroscope, with reference to a detection axis, according to an aspect of the present solution;
- Figure 3 is a detailed top plan view of a detection structure of a triaxial MEMS gyroscope, according to a first embodiment of the present solution;
- Figure 4 is a schematic top plan view of the detection structure of Figure 3, with reference to a driving movement;
- Figure 5A is a schematic top plan view of the detection structure of Figure 3, with reference to a roll-detection movement;
- Figure 5B is a schematic cross-sectional illustration of a portion of the detection structure of Figure 5A, with reference to the capacity, in roll-detection mode, of rejection of linear or angular vibrations;
- Figure 6A is a schematic top plan view of the detection structure of Figure 3, with reference to a pitch-detection movement;
- Figure 6B is a schematic cross-sectional illustration of a portion of the detection structure of Figure 6A, with reference to the capacity, in pitch-detection mode, of rejection of linear or angular vibrations;
- Figure 7A is a schematic top plan view of the detection structure of Figure 3, with reference to a yaw-detection movement;
- Figure 7B is a schematic top plan view of a portion of the detection structure of Figure 7A, with reference to the capacity, in yaw-detection mode, of rejection of linear or angular vibrations;
- Figure 8 is a schematic top plan view of the detection structure of a triaxial MEMS gyroscope, according to a second embodiment of the present solution;
- Figure 9 is a schematic top plan view of the detection structure of Figure 8, with reference to a driving movement;
- Figure 10 is a schematic top plan view of the detection structure of Figure 8, with reference to a roll-detection movement;
- Figure 11 is a schematic top plan view of the detection structure of Figure 8, with reference to a pitch-detection movement;
- Figure 12A is a schematic top plan view of the detection structure of Figure 8, with reference to a yaw-detection movement; and
- Figure 12B is a schematic top plan view of a portion of the detection structure of Figure 12A, with reference to the capacity, in yaw-detection mode, of rejection of linear or angular vibrations.

### DESCRIPTION OF EMBODIMENTS

As illustrated schematically in Figure 2 (with reference by way of example to a possible detection axis), according to an aspect of the present solution the architecture of the detection structure of the MEMS gyroscope comprises, for each detection axis, two pairs of detection masses, with an arrangement symmetrical with respect to a central axis of symmetry S, about which an angular oscillation of disturbance may occur.

The detection structure, designated by 10, thus comprises in this case: a first pair of detection masses, denoted by M1, M2, arranged on a first side of the central axis of symmetry S; and a second pair of detection masses, denoted by M1', M2', arranged on a second side of the central axis of symmetry S, opposite to the aforesaid first side (in the horizontal plane xy).

The detection masses of each pair M1, M2, M1', M2' are capacitively coupled to a respective stator electrode S1, S2, S1', S2' according to a differential detection scheme (designed to generate, after an appropriate processing of the resulting capacitive variation, an electrical output signal Sₒᵤₜ), the stator electrodes being thus arranged with central symmetry, arranged in pairs symmetrically on opposite sides of the central axis of symmetry S and constituting a positive electrode '+' (the stator electrodes S1, S1' being arranged, in the example, in a position further away from the central axis of symmetry S, electrically connected together) and, respectively, a negative electrode "-" (the stator electrodes S2, S2' being arranged, in the example, in a position closer to the central axis of symmetry S, electrically connected together), so as to implement the differential detection scheme.

Basically, the stator electrodes defining the aforesaid positive electrode and the stator electrodes defining the aforesaid negative electrode are arranged in pairs in a symmetrical way.

This configuration of the detection masses evidently enables rejection, thanks to the differential detection scheme, not only of linear accelerations of disturbance (indicated once again by the arrow V_{L} in the aforesaid Figure 2), but also of angular accelerations of disturbance (denoted by V_{A}) acting about the central axis of symmetry S, which in fact produce concordant movements of the detection masses of each pair on each side of the central axis of symmetry S (contrary to the movement in phase opposition due to the Coriolis force), thus generating a zero resulting effect as regards the output signal Sₒᵤₜ.

As indicated in the same Figure 2, the detection masses of each pair are suitably driven in phase opposition by the Drive movement, so as to generate forces and respective movements by the Coriolis effect, opposite to one another, on each side of the central axis of symmetry S.

The detection masses M1, M1', arranged in positions further away from the central axis of symmetry S, have, at the instant represented, a detection movement (once again indicated by the arrow Co) in a first direction along the vertical axis z (in the example, a movement of approach to the respective stator electrodes S1, S1'), whereas the detection masses M2, M2' arranged, in the example, in a position closer to the central axis of symmetry S have a detection movement in a second direction along the vertical axis z, opposite to the first direction (in the example, moving away from the respective stator electrodes S2, S2').

Consequently, the arrangement of the detection masses and of the respective stator electrodes and the differential configuration of the capacitive coupling with the same stator electrodes advantageously enables generation of an output signal Sₒᵤₜ, that is indicative of the angular velocity of interest about a respective detection axis and is insensitive to linear or angular vibrational disturbance.

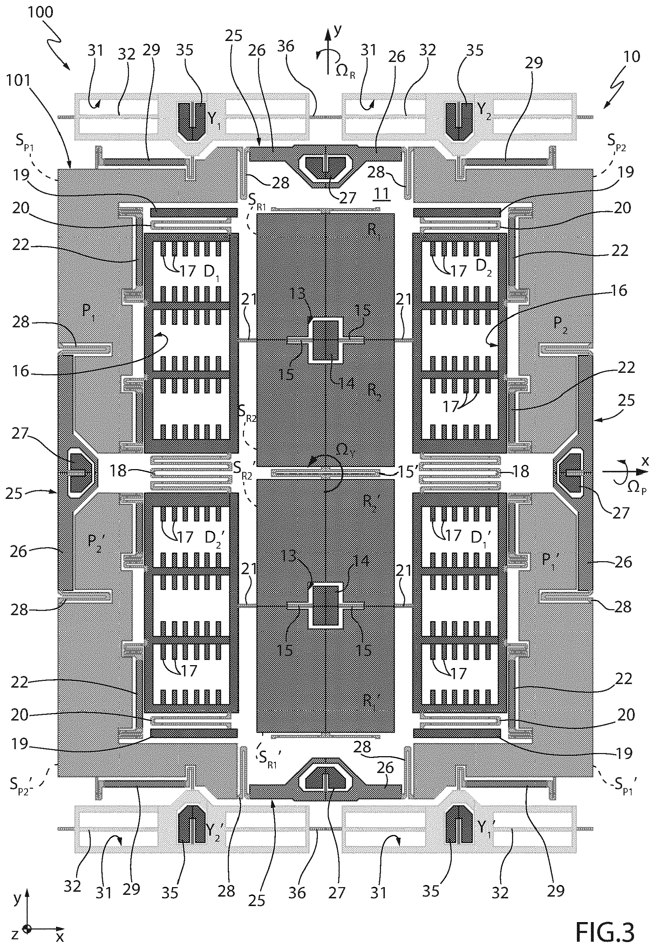

With reference first to Figure 3, a first embodiment of the detection structure, once again designated by 10, of a MEMS gyroscope of a triaxial type 100 is now described in more details, where the architecture described previously is adopted for each of the detection axes, namely, the axes of roll, pitch, and yaw, so as to obtain the desired improved rejection of the (linear and/or angular) vibrational disturbance.

The detection structure 10 is provided in a die 101 of semiconductor material, for example silicon, comprising a substrate 11, is suspended above the substrate 11, and has a complete symmetry with respect to a first central axis, which coincides with a first horizontal axis x of a horizontal plane xy of main extension of the detection structure 10. In particular, the first horizontal axis x coincides with a pitch detection axis of the detection structure 10, about which a pitch angular velocity Ωₚ may be detected.

The detection structure 10 is further completely symmetrical with respect to a second horizontal axis y, which forms, with the first horizontal axis x, the aforesaid horizontal plane xy and coincides with a roll-detection axis of the detection structure 10, about which a roll angular velocity Ωᵣ may be detected.

The detection structure 10 has an extension (thickness) smaller than the aforesaid main extension along a vertical axis z, orthogonal to the aforesaid horizontal plane xy and coinciding with a yaw-detection axis, about which a yaw angular velocity Ω_{y} may be detected.

The detection structure 10 comprises a first pair of roll-detection masses R1, R2 and a second pair of roll-detection masses R1', R2', arranged symmetrically and on opposite sides with respect to the first horizontal axis x and suspended above the substrate 11, at a certain separation distance along the vertical axis z.

In this embodiment, the roll-detection masses R1, R2, R1', R2' of each pair are fixedly coupled together to form a single body (so as to jointly define a first roll detection mass R1,R2, formed by the first pair of roll-detection masses, and a second roll detection mass R1',R2', formed by the second pair of roll detection masses, these first and second roll detection masses being arranged on opposite sides of the first horizontal axis x). The above-defined single body has a substantially rectangular extension along the second horizontal axis y and centrally defines a window 13, arranged within which is a respective roll anchorage 14, fixedly connected to the substrate 11 (this roll anchorage 14 having, for example, a substantially column-like conformation that extends as far as the substrate 11, being coupled integrally to the same substrate 11).

Elastic anchorage elements 15, of a torsional type, connect the roll-detection masses R1, R2, R1', R2' of each pair to the respective anchorage 14 within the window 13. In particular, these elastic anchorage elements 15 have a longitudinal extension along the first horizontal axis x and are arranged on opposite sides of the roll anchorage 14 with respect to the second horizontal axis y.

The pairs of roll-detection masses R1, R2, R1', R2' are elastically coupled together by an elastic coupling element 15', arranged in a position corresponding to the first horizontal axis x and having a stiffness such as to allow motion of the two masses both along the first horizontal axis x and along the vertical axis z and, at the same time, such as to keep them constrained to one another.

Respective roll stator electrodes S_{R}1, S_{R}2, S_{R}1', S_{R}2' (illustrated schematically) are arranged underneath the roll-detection masses R1, R2, R1', R2' of each pair, capacitively coupled to the respective roll-detection masses R1, R2, R1', R2' and positioned on the substrate 11 (so as to provide a differential detection scheme, as discussed previously with reference to Figure 2).

The detection structure 10 further comprises a first pair and a second pair of driving masses D1, D2 and D1', D2', which are arranged alongside and on the outside of the roll-detection masses R1, R2, R1', R2' of the first pair and the second pair, respectively, on opposite sides with respect to the first horizontal axis x, and are also suspended above the substrate 11 at a certain separation distance along the vertical axis z.

The above driving masses D1, D2, D1', D2' have, for example, a substantially rectangular-frame conformation along the second horizontal axis y, internally defining windows 16 for mobile driving electrodes 17, which are fixed with respect to the frames and are combfingered with corresponding fixed driving electrodes (not illustrated, for reasons of clarity of representation), which are also arranged within the same windows 16.

In a way not illustrated in detail, in the frames of the driving masses D1, D2, D1', D2' electrodes for detecting the driving movement may further be provided, being designed to provide s feedback indication of the driving movement.

Each driving mass D1, D2 of the first pair is coupled to a respective driving mass D2', D1' of the second pair (arranged symmetrically with respect to the first horizontal axis x) through a respective elastic coupling element 18, of a folded type, having an extension along the second horizontal axis y.

The driving masses D1, D2, D1', D2' are coupled to respective driving anchorages 19, which are fixed with respect to the substrate 11 and are arranged on opposite sides with respect to the respective elastic coupling element 18, i.e., at a distance from the first horizontal axis x, through a respective elastic anchorage element 20, which is also of a folded type.

Each of the driving masses D1, D2, D1', D2' is further coupled centrally to a respective one of the roll-detection masses R1, R2, R1', R2' through a respective elastic driving element 21, of a torsional type, having a linear extension directed longitudinally along the first horizontal axis x.

The detection structure 10 moreover comprises a first pair and a second pair of pitch-detection masses P1, P2 and P1', P2', which are arranged alongside and on the outside of the driving masses D1, D2, D1', D2' of the first pair and, respectively, of the second pair, on opposite sides with respect to the first horizontal axis x, and are also suspended above the substrate 11 at a certain separation distance along the vertical axis z.

The above pitch-detection masses P1, P2, P1', P2' are, for example, substantially L-shaped, with the long side extending along the second horizontal axis y and the short side extending along the first horizontal axis x.

Arranged underneath the pitch-detection masses P1, P2, P1', P2' of each pair, as discussed for the roll-detection masses, are respective pitch stator electrodes Sp1, Sp2, S_{P}1', S_{P}2' (illustrated schematically), capacitively coupled to the respective pitch-detection masses P1, P2, P1', P2' and positioned on the substrate 11 (so as to provide a differential detection scheme, as discussed previously with reference to Figure 2).

Each pitch-detection mass P1, P2, P1', P2' is coupled to a respective driving mass D1, D2, D1', D2' through respective driving elastic-coupling elements 22, which have an extension along the second horizontal axis y, folded end portions, and a central portion with linear extension. In detail, in the embodiment illustrated in the aforesaid Figure 3, each pitch-detection mass P1, P2, P1', P2' is coupled to a respective driving mass D1, D2, D1', D2' by means of two respective driving elastic-coupling elements 22, connected to a respective end portion of the long side of the same pitch-detection mass P1, P2, P1', P2'.

Furthermore, the pitch-detection masses P1, P2, P1', P2' are coupled together two by two by respective elastic-coupling structures 25, which extend centrally, crossing the first horizontal axis x or the second horizontal axis y, between respective end portions of long sides, or short sides, of the pitch-detection masses P1, P2, P1', P2'. Basically, as on the other hand is evident from an examination of the aforesaid Figure 3, the pitch-detection masses P1, P2, P1', P2' and the aforesaid elastic-coupling structures 25 define, as a whole, a rectangular frame, enclosed inside which are the driving masses D1, D2, D1', D2' and the roll-detection masses R1, R2, R1', R2'.

In detail, each elastic-coupling structure 25 defines an elastic lever element 26, of a central-fulcrum type, hinged to the substrate 11 through a central anchorage 27 and coupled at its ends to the respective pitch-detection masses P1, P2, P1', P2' by means of respective folded elastic elements 28.

The detection structure 10 further comprises, in this embodiment, a first pair and a second pair of yaw-detection masses Y1,Y2, Y1',Y2', which are arranged externally to the pitch-detection masses P1, P2, P1', P2' of the first pair and, respectively, the second pair, on opposite sides with respect to the first horizontal axis x, and are suspended over the substrate 11 at a certain separation distance along the vertical axis z.

Each yaw-detection mass Y1,Y2, Y1',Y2' is elastically coupled to a respective pitch-detection mass P1, P2, P1', P2' by a respective yaw elastic-coupling element 29, with an extension along the first horizontal axis x (in a position arranged between the same pitch-detection and yaw-detection masses), having folded end portions and a central portion with linear extension.

The aforesaid yaw-detection masses Y1,Y2, Y1',Y2' have a substantially rectangular-frame conformation along the first horizontal axis x, internally defining windows 31 for mobile yaw-detection electrodes 32, which are fixed with respect to the frames and alternate with corresponding fixed detection electrodes or yaw stator electrodes S_{Y}1, S_{Y}2, S_{Y}1', S_{y}2' (not illustrated herein, for reasons of clarity of representation), which are also arranged within the windows 31.

The same yaw-detection masses Y1,Y2, Y1',Y2' are further elastically coupled to a yaw anchorage 35, which is arranged centrally to the corresponding frame. Furthermore, the yaw-detection masses Y1,Y2, Y1',Y2' of each pair are elastically coupled together by an elastic coupling element 36, with linear extension along the first horizontal axis x and arranged between the corresponding frames.

It is thus underlined that, in the solution described, for each detection axis a first set of the aforesaid stator electrodes (S1, S1') are electrically connected together to form a positive detection electrode for the differential detection scheme, and a second set of the aforesaid stator electrodes (S2, S2') are electrically connected together to form a negative detection electrode for the same differential detection scheme, the electrodes of the first set being arranged with respect to the electrodes of the second set with central symmetry (in the case of the pitch- and roll-detection axes) or axial symmetry (in the case of the yaw-detection axis, the axis of symmetry coinciding with the aforesaid second horizontal axis y) .

Operation of the detection structure 10 is now described, for detection of the aforesaid roll, pitch, and yaw angular velocities Ω_{R}, Ω_{P}, Ω_{Y}.

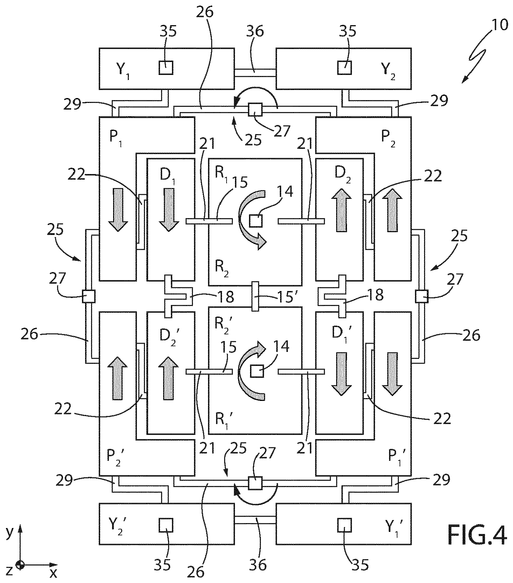

As illustrated schematically in Figure 4, the driving movement envisages that the driving masses D1, D2, D1', D2' are driven (by appropriate biasing of the mobile driving electrodes 17 and of the corresponding fixed driving electrodes) so as to carry out a movement of translation (in phase opposition for each pair) along the second horizontal axis y. Furthermore, movement of the driving masses D1, D2' and D2, D1', mutually symmetrical with respect to the first horizontal axis x, is also in phase opposition.

As indicated by the arrows in the above Figure 4, the aforesaid movement of the driving masses D1, D2, D1', D2' causes, as a result of the elastic couplings, a rotation in phase opposition of the roll-detection masses R1, R2, R1', R2' of the two pairs (the masses of each pair moving fixedly with respect to one another) in the horizontal plane xy, about an axis parallel to the vertical axis z and passing through the centre of the respective roll anchorage 14.

Furthermore, the pitch masses P1, P2, P1', P2' are driven (or dragged) by the driving masses D1, D2, D1', D2' into a corresponding movement of translation in phase opposition along the second horizontal axis y. This movement in turn entails rotation in the horizontal plane xy about the respective central anchorage 27 of the elastic lever elements 26 of the elastic-coupling structures 25 that couple together the pitch-detection masses P1 and P2, P1' and P2' of a same pair (the remaining elastic-coupling structures 25 remain stationary). The yaw-detection masses Y1,Y2, Y1',Y2' are further fixedly coupled to the respective pitch-detection masses P1, P2, P1', P2' during the corresponding driving movement.

The aforesaid driving movements thus take place entirely in the horizontal plane xy and do not involve further elements of the detection structure 10.

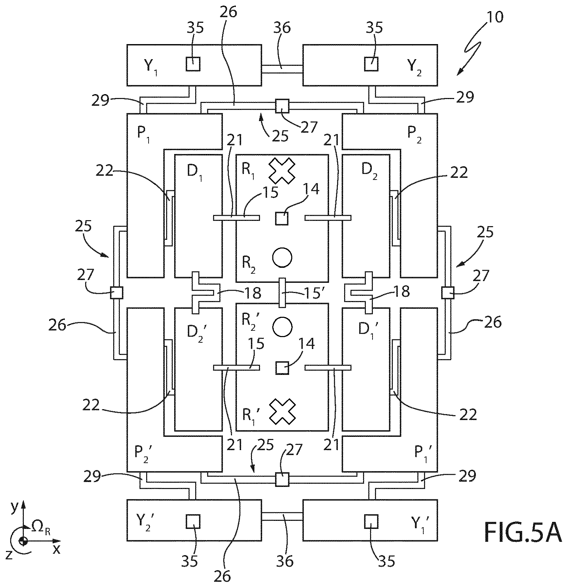

As illustrated schematically in Figure 5A (which regards a given operating instant), in the presence of a roll angular velocity Ω_{R} about the second horizontal axis y, the motion of the detection structure 10 envisages a rotation in phase opposition of the set of roll-detection masses R1, R2, R1', R2' of each pair about the axis of rotation defined by the respective elastic anchorage elements 15 and by the respective elastic driving elements 21, which are parallel to the first horizontal axis x.

Basically, as is on the other hand represented schematically in Figure 5A, the roll-detection masses of each pair R1, R2, R1', R2' carry out, as a result of the resulting Coriolis force, a movement, along the vertical axis z, moving away from or approaching the respective roll stator electrodes S_{R}1, S_{R}2, S_{R}1', S_{R}2' (here not illustrated), causing, as a whole, a capacitive variation that may be detected by the differential detection scheme.

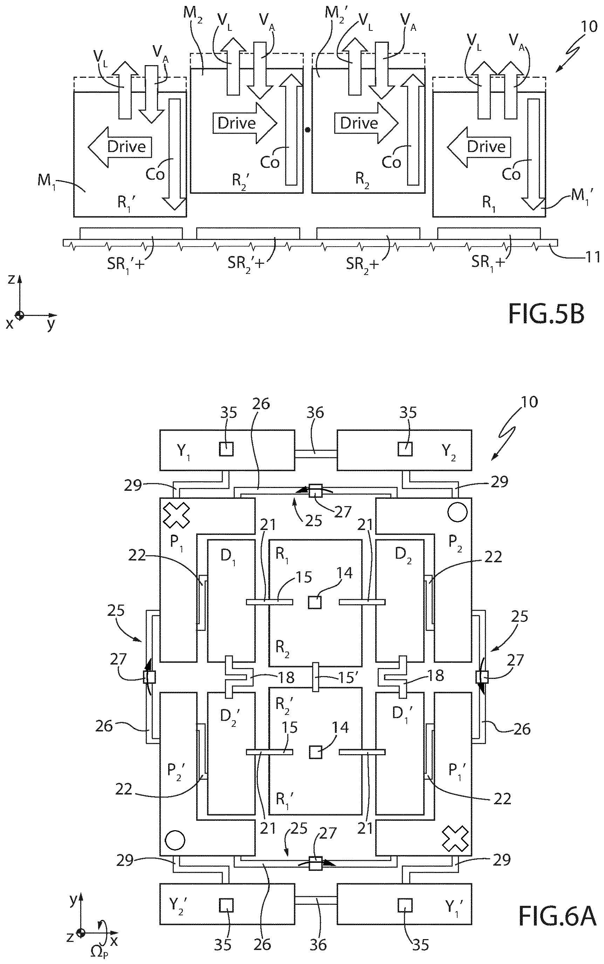

Figure 5B (which regards the given operating instant) shows schematically, in addition to the aforementioned driving and roll-detection movements (as a result of the Coriolis forces Co), the effect both of a linear acceleration of disturbance V_{L} (along the vertical axis z) and of an angular acceleration V_{A} of disturbance (which acts about the first horizontal axis x and thus causes a movement of rotation of the set of the roll-detection masses R1, R2, R1', R2' about the first horizontal axis x).

It is evident how the linear acceleration causes an in-phase movement of all the roll-detection masses R1, R2, R1', R2', which is thus rejected by the differential detection scheme. Likewise, the angular acceleration V_{A} of disturbance causes an in-phase movement of the roll-detection masses R1 and R2, R1' and R2' of each pair (for example, at the operating instant represented, both of the roll-detection masses R1, R2 of the first pair move away from and the roll-detection masses R1', R2' of the second pair move towards the substrate 11 and to the corresponding roll stator electrodes).

It is consequently evident that, also in this case, the differential detection scheme enables elimination of the effects due to the angular acceleration of disturbance, which thus do not affect the output signal Sₒᵤₜ, unlike the roll angular velocity Ω_{R} that is to be detected.

As illustrated schematically in Figure 6A (which regards a given operating instant), in the presence of a pitch angular velocity Ω_{P} about the first horizontal axis x, the motion of the detection structure 10 envisages a displacement in phase opposition of the pitch-detection masses P1, P2, P1', P2' of each pair along the vertical axis z (and furthermore the movement in phase opposition, along the same vertical axis z, of the pitch-detection masses P1, P2', P2, P1' that are mutually symmetrical with respect to the first horizontal axis x).

This movement of the pitch-detection masses P1, P2, P1', P2' is allowed by rotation of the elastic lever elements 26 of all the elastic-coupling structures 25 about the central anchorage 27, out of the horizontal plane xy along the vertical axis z (as illustrated schematically in the aforesaid Figure 6A).

Basically, the pitch-detection masses P1, P2, P1', P2' carry out, as a result of the Coriolis force, a movement, along the vertical axis z, moving away from/approaching to the respective pitch stator electrodes S_{P}1, S_{P}2, S_{P}1', S_{P}2', causing, as a whole, a capacitive variation that may be detected by the aforementioned differential detection scheme.

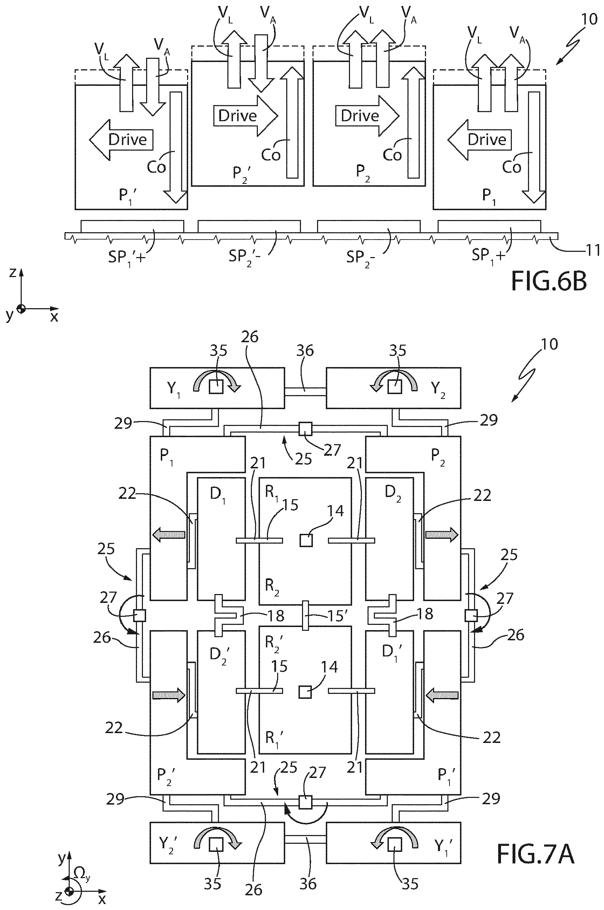

As illustrated schematically in Figure 6B (which regards the given operating instant), also in this detection mode, a linear acceleration V_{L} causes an in-phase movement of all the pitch-detection masses P1, P2, P1', P2', which is rejected by the differential detection scheme. Likewise, an angular acceleration V_{A} of disturbance, acting about the first horizontal axis x, causes an in-phase movement of the pitch-detection masses P1 and P2, P1' and P2' of each pair (for example, both pitch-detection masses P1, P2 of the first pair move away from and the pitch-detection masses P1', P2' of the second pair approach the substrate 11).

It is thus evident that also in this case, the differential detection scheme enables elimination of the effects linked both to the linear vibrations and to the angular vibrations of disturbance.

As illustrated schematically in Figure 7A, in the presence of a yaw angular velocity Ω_{Y} about the vertical axis z, the motion of detection of the detection structure 10 envisages a displacement in phase opposition of the pitch-detection masses P1, P2, P1', P2' of each pair along the first horizontal axis x and, consequently (as a result of the elastic coupling) the movement in phase opposition of rotation of the yaw-detection masses Y1,Y2, Y1',Y2' of each pair in the horizontal plane xy, about the respective yaw anchorage 35. In particular, the yaw-detection masses Y1,Y2, Y1',Y2' are drawn (or dragged) along by the pitch masses P1, P2, P1', P2' by the corresponding yaw elastic-coupling elements 29 that move along the first horizontal axis x.

The movement described further entails rotation in the horizontal plane xy about the respective central anchorage 27 of the elastic lever elements 26 of the elastic-coupling structures 25 that couple together the pitch-detection masses P1, P2', P2, P1' that are mutually symmetrical with respect to the first horizontal axis x.

A movement of the yaw mobile electrodes 32 (not illustrated herein) thus occurs along the second horizontal axis y, with respect to the alternating yaw stator electrodes, and a consequent capacitive variation that may be detected by the differential scheme.

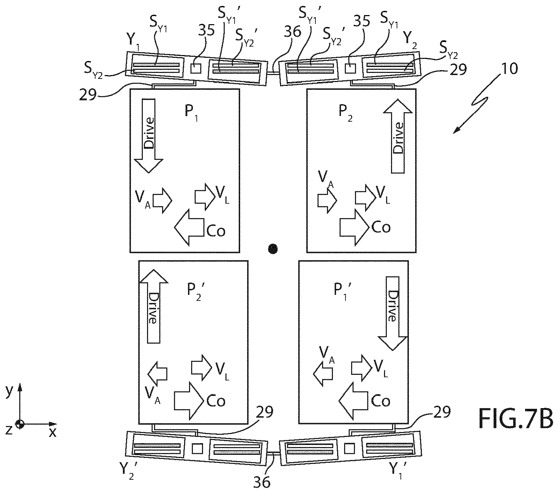

As highlighted in Figure 7B, also in this detection mode, a linear acceleration V_{L} causes an in-phase movement of all the yaw-detection masses Y1,Y2, Y1',Y2', which substantially do not produce capacitive variations between the yaw-detection electrodes. Furthermore, an angular acceleration V_{A} of disturbance (acting in this case about the vertical axis z at the centre of the detection structure 10, in the horizontal plane xy) causes an in-phase movement of the yaw-detection masses Y1 and Y2, Y1' and Y2' of each pair and thus corresponding movements of recession or approach, between the mobile and fixed yaw-detection electrodes S_{Y}1 and S_{Y}2, S_{Y}1' and S_{Y}2' that alternate with one another (here illustrated schematically and with different colouring for the positive electrodes '+' and negative electrode `-' for the differential detection scheme).

It is thus evident that also in this case, the differential detection scheme enables elimination of the effects linked both to the linear accelerations of disturbance and to the angular vibrations of disturbance.

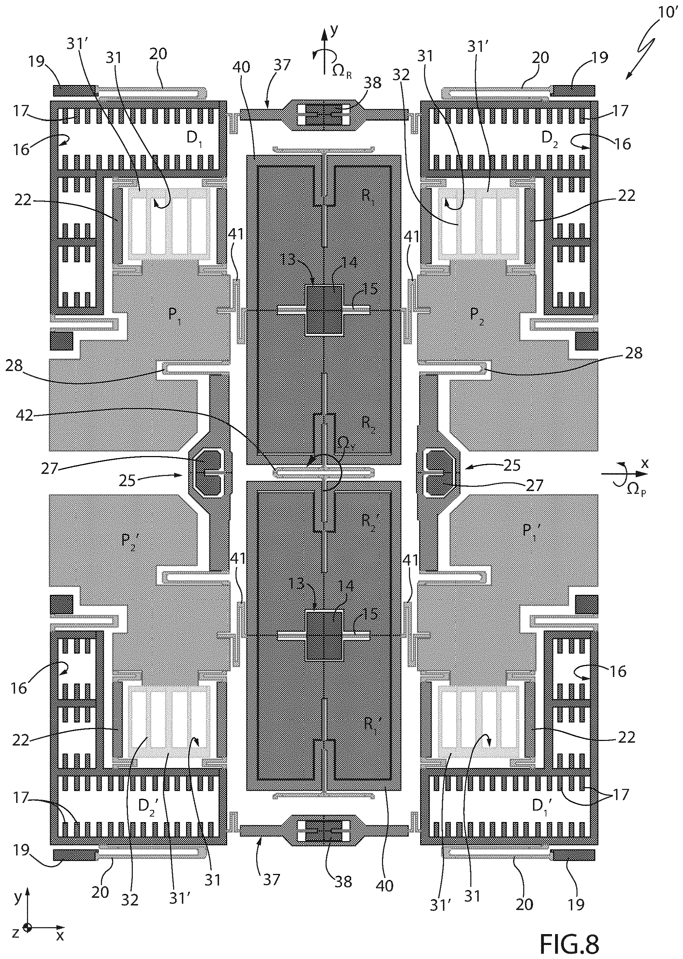

With reference to Figure 8, a second embodiment of the detection structure, designated here by 10', is now described.

As illustrated schematically in the above Figure 8, the substantial difference as compared to the first embodiment consists in the absence of the distinct yaw-detection masses. In this embodiment, in fact, the pitch-detection masses P1, P2, P1', P2' define internally also the yaw-detection masses and contain within them frames 31' that internally define the windows 31 for the mobile yaw-detection electrodes 32, which alternate with the corresponding fixed yaw-detection electrodes (not illustrated) and are designed for detecting the yaw angular velocity Ω_{Y} about the vertical axis z.

In this embodiment, the driving masses D1, D2, D1', D2' are arranged, in the horizontal plane xy, externally with respect to the aforesaid pitch-detection masses P1, P2, P1', P2', which are thus arranged between a respective driving mass D1, D2, D1', D2' and a respective roll-detection mass R1, R2, R1', R2'.

Each pitch-detection mass P1, P2, P1', P2' is also in this case coupled to a respective driving mass D1, D2, D1', D2' by respective driving elastic-coupling elements 22, which have an extension along the second horizontal axis y.

The driving masses D1 and D2, D1' and D2' of each pair are in this case elastically coupled together by a respective elastic-coupling structure, designated by 37, which defines an elastic central-fulcrum lever element, hinged to the substrate 11 by a central anchorage 38.

In this second embodiment, the roll-detection masses R1 and R2, R1' and R2' of each pair (fixed with respect to one another, as in the first embodiment) are surrounded in the horizontal plane xy by a respective rigid ring structure 40; an elastic central element 42, of a torsional type and with a rectangular-frame conformation, arranged in a position corresponding to the first horizontal axis x, elastically couples the ring structures 40 associated to the two pairs of roll-detection masses R1, R2, R1', R2'.

The pitch-detection masses P1 and P2, P1' and P2' of each pair are in this case coupled together by the aforesaid ring structure 40; in particular, the pitch-detection masses P1 and P2, P1' and P2' of each pair are coupled to a respective ring structure 40 through respective elastic elements 41, of the folded type, at a central portion of the same ring structure 40 (aligned to the elastic anchorage elements 15 along the first horizontal axis x).

Furthermore, the pitch-detection masses P1, P2', P2, P1' that are mutually symmetrical with respect to the first horizontal axis x are once again coupled by the central-fulcrum elastic-coupling structures 25, which are hinged to the substrate 11 by the respective central anchorage 27.

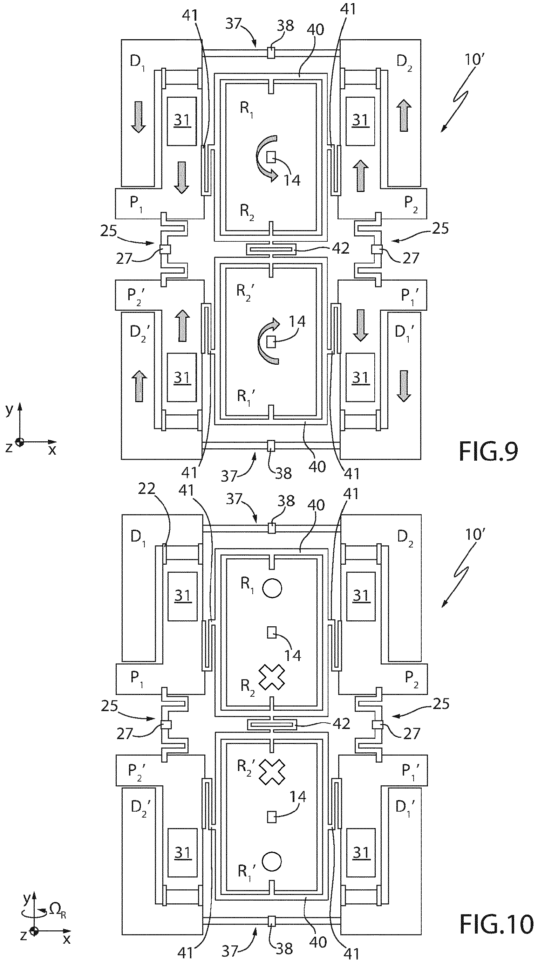

As illustrated schematically in Figure 9A, the driving movement of the detection structure 10' is substantially equivalent to what has been described with reference to the first embodiment.

The driving masses D1, D2, D1', D2' are in fact driven (by appropriate biasing of the mobile driving electrodes and of the alternating fixed driving electrodes, not illustrated) so as to carry out a movement of translation in phase opposition along the second horizontal axis y, which carries, in a similar movement of translation, the pitch-detection masses P1, P2, P1', P2' and further entails rotation in the horizontal plane xy, about the respective central anchorage 38, of the elastic lever elements of the elastic-coupling structures 37 that couple together the driving masses D1, D2, D1', D2' of each pair.

Furthermore, the movement of the driving masses D1, D2' and D2, D1' (that are mutually symmetrical with respect to the first horizontal axis x) causes, as a result of the elastic couplings, a rotation in phase opposition of the roll-detection masses R1, R2, R1', R2' of the two pairs in the horizontal plane xy, about an axis parallel to the vertical axis z and passing through the centre of the respective roll anchorage 14.

Once again in a way similar to what has been described for the first embodiment, and as illustrated schematically in Figure 10, in the presence of a roll angular velocity Ω_{R} about the second horizontal axis y, motion of the detection structure 10' envisages a rotation in phase opposition of the roll-detection masses R1, R2, R1', R2' about the axis of rotation defined by the respective elastic elements and parallel to the first horizontal axis x.

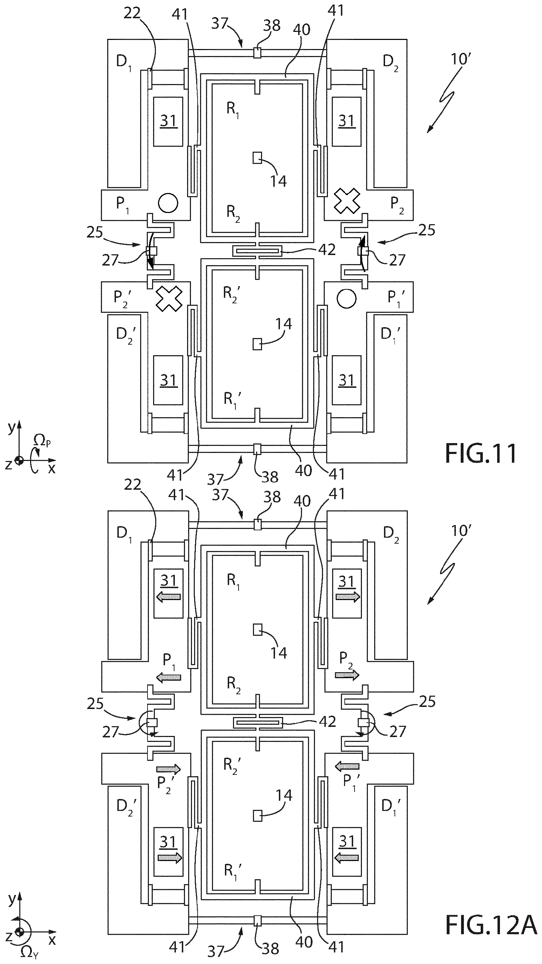

As illustrated in Figure 11, in the presence of a pitch angular velocity Ω_{P} about the first horizontal axis x, motion of the detection structure 10' also envisages in this embodiment a displacement in phase opposition of the pitch-detection masses P1, P2, P1', P2' of each pair along the vertical axis z (and further the movement in-phase opposition of the pitch-detection masses P1, P2', P2, P1' that are mutually symmetrical with respect to the first horizontal axis x).

As described for the first embodiment, this movement of the pitch-detection masses P1, P2, P1', P2' is enabled by rotation of the respective elastic lever elements of the elastic-coupling structures 25 that couple the pitch-detection masses P1, P2', P2, P1' that are mutually symmetrical with respect to the first horizontal axis x, a movement that occurs about the corresponding central anchorage 27, out of the horizontal plane xy (along the vertical axis z) . In this second embodiment, coupling between the pitch-detection masses P1, P2', P2, P1' is further provided by the corresponding ring structures 40, which rotate about the second horizontal axis y, out of the horizontal plane xy.

As illustrated in Figure 12A, in the presence of a yaw angular velocity Ω_{Y} about the vertical axis z, motion of the detection structure 10' envisages a displacement of translation in phase opposition of the pitch-detection masses P1, P2, P1', P2' of each pair, along the first horizontal axis x and, consequently, a corresponding movement along the first horizontal axis x of the mobile and fixed yaw-detection electrodes within the frames 31, which are fixed with respect to the pitch-detection masses P1, P2, P1', P2', causing a variation of the capacitive coupling that may be detected by the differential detection scheme.

In a way that will be clear from what has been described, considerations altogether similar to those mentioned for the first embodiment also apply to this second embodiment as regards rejection of the linear and angular accelerations of disturbance (such considerations will thus not in general be repeated).

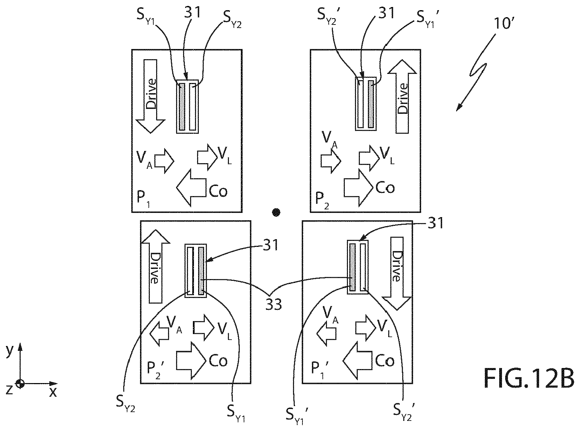

With reference to Figure 12B, merely for completeness the schematic representation is provided for the aforesaid movement of yaw of the detection structure 10' in so far as it differs in part from the one described for the first embodiment.

In this detection mode, a linear acceleration V_{L} causes an in-phase movement of all the pitch-detection masses P1, P2, P1', P2' along the first horizontal axis x and a consequent concordant movement of the mobile yaw-detection electrodes, thus entailing a capacitive variation with respect to the fixed yaw-detection electrodes S_{Y}1 and S_{Y}2, Sy1' and S_{Y}2', which is rejected by the differential detection scheme (the electrodes are once again illustrated schematically and with different colouring for the positive electrodes '+' and negative electrode `-' for the differential detection scheme).

Likewise, an angular acceleration of disturbance (acting in this case about the centre of the detection structure 10' and about the vertical axis z, in the horizontal plane xy) causes an in-phase movement of the pitch-detection masses P1, P2, P1', P2' of each pair (the movements of the pairs being in mutually opposite directions) and, thus, corresponding opposite movements of recession or approach between the mobile and fixed yaw-detection electrodes, which alternate with one another.

It is thus evident that, also in this case, the differential detection scheme enables elimination of the effects linked both to the linear accelerations and to the angular accelerations of disturbance.

The advantages of the solution proposed emerge clearly from the foregoing description.

In any case, it is underlined that the solution described allows to obtain an improved vibration rejection (in particular, of angular vibrations, in addition to linear vibrations), without entailing any substantial increase in the area occupied by the detection structure and without entailing any increase of electrical consumption as compared to known solutions.

In addition, it is underlined that the second embodiment described has the advantage of having a simpler architecture (without the presence of the four additional yaw-detection masses), with the disadvantage, however, of a possible presence of spurious modes as regards the movement of yaw.

Finally, it is clear that modifications and variations may be made to what has been described and illustrated herein, without thereby departing from the scope of the present invention, as defined in the annexed claims.

In particular, it is underlined that the position of the various detection masses in the detection structure and the configuration of the associated elastic couplings and anchorages may differ from what has been illustrated in detail herein for the first and second embodiments.

For instance, the roll-detection masses R1, R2, R1', R2' of each pair might not be fixedly coupled together, but be distinct and coupled together in a suitable manner.

Further, it is pointed out that the solution described could advantageously be applied also for detection structures of biaxial or also uniaxial gyroscopes, maintaining the advantageous characteristics of improved insensitivity to vibrational disturbance of a linear or angular nature.

## Claims

1. A triaxial microelectromechanical gyroscope (100), provided in a die (101) of semiconductor material and comprising a substrate (11) and a detection structure (10;10') suspended over said substrate (11), wherein said detection structure (10;10') has a main extension in a horizontal plane (xy) and is symmetrical with respect to a first horizontal axis (x) and to a second horizontal axis (y), forming with the first horizontal axis (x) said horizontal plane (xy);
wherein said detection structure (10;10') comprises:
a first roll detection mass (R1,R2) and a second roll detection mass (R1',R2'), arranged symmetrically and on opposite sides with respect to the fist horizontal axis (x);
a first pair of driving masses (D1,D2) and a second pair of driving masses (D1',D2'), wherein the driving masses of the first pair (D1, D2) are arranged laterally and externally to the first roll detection mass (R1,R2) and the driving masses of the second pair (D1', D2') are arranged laterally and externally to the second roll detection mass (R1',R2'), in the horizontal plane (xy), symmetrically with respect to said second horizontal axis (y);
a first pair of pitch detection masses (P1,P2) and a second pair of pitch detection masses (P1', P2'), wherein the pitch detection masses of the first pair (P1, P2) are arranged laterally and externally to the first roll detection mass (R1,R2) and the pitch detection masses of the second pair (P1', P2') are arranged laterally and externally to the second roll detection mass (R1',R2'), in the horizontal plane (xy), symmetrically with respect to said second horizontal axis (y), and wherein each pitch detection mass (P1,P2, P1', P2') is coupled to a respective driving mass (D1,D2, D1', D2') by respective driving elastic-coupling elements (22);
a first and a second pairs of yaw detection elements (31, 32), coupled to the pitch detection masses (P1,P2, P1',P2') of the first, respectively second, pair,
wherein said driving masses (D1,D2, D1',D2') are configured to be driven to execute a translation movement, in opposite directions for each pair, along the second horizontal axis (y), the movement of the driving masses (D1,D2, D1', D2') symmetrical with each other with respect to the first horizontal axis (x) being also in opposite directions; wherein movement of the driving masses is designed to cause an opposite-phase rotation of the first and second roll detection masses (R1,R2, R1',R2') in the horizontal plane (xy) and moreover a corresponding translation movement in opposite directions along the second horizontal axis (y) of said pitch detection masses (P1,P2, P1',P2'), drawn by said driving masses (D1,D2, D1',D2'); wherein, in said driving movement, said yaw detection elements (31, 32) are rigidly coupled with the respective pitch detection masses (P1,P2, P1', P2').

2. The gyroscope according to claim 1, wherein respective roll stator electrodes (S_{R}1, S_{R}2, S_{R}1', S_{R}2') are arranged underneath the first and second roll-detection masses (R1,R2, R1',R2'), capacitively coupled to the respective roll-detection masses (R1,R2, R1',R2') and positioned on the substrate (11) so as to provide a differential detection scheme; respective pitch stator electrodes (S_{P}1,S_{P}2, S_{P}1',S_{P}2') are arranged underneath the pitch detection masses (P1,P2, P1',P2') of each pair, capacitively coupled to the respective pitch detection masses (P1,P2, P1',P2') and positioned on the substrate (11) so as to provide a respective differential detection scheme; and wherein said yaw detection elements (31) have a substantially frame conformation internally defining windows for mobile yaw detection electrodes (32), which are alternate and capacitively coupled with corresponding fixed yaw detection electrodes (S_{Y}1,S_{Y}2, S_{Y}1',S_{y}2') so as to provide a respective differential detection scheme; wherein in said differential detection scheme an angular velocity about a respective detection axis causes a detectable variation of a detection capacitance resulting from the capacitive coupling, so as to determine a variation of an output signal (Sₒᵤₜ) associated with said differential detection scheme, and so that linear vibrations (V_{L}) or angular vibrations (V_{A}) do not cause substantially any variation of said detection capacitance.

3. The gyroscope according to claim 2, wherein in the presence of said linear vibrations (V_{L}) or angular vibrations (V_{A}) the first and second roll detection masses (R1,R2, R1',R2') are configured to perform in-phase rotation movements in the horizontal plane (xy); and moreover said pitch detection masses (P1,P2, P1',P2') are configured to perform corresponding in-phase movements along the second horizontal axis (y).

4. The gyroscope according to any one of the preceding claims, wherein each of said first and second roll-detection masses (R1,R2, R1',R2') centrally defines a window (13), arranged within which is a respective roll anchorage (14), fixedly connected to the substrate (11), elastic anchorage elements (15), of a torsional type, connecting each of said first and second roll-detection masses (R1,R2, R1',R2') to the respective anchorage (14); wherein, in the presence of a roll angular velocity (Ωᵣ) about the second horizontal axis (y), movement of the detection structure (10;10') is configured to implement an opposite-phase rotation of the first and second roll detection masses (R1,R2, R1',R2') about the rotation axis defined by the respective elastic anchorage elements (15), outside of the horizontal plane (xy).

5. The gyroscope according to any of the preceding claims, wherein each pitch detection mass (P1,P2) of the first pair is coupled to a respective pitch detection mass (P1',P2') of the second pair, arranged symmetrically with respect to the first horizontal axis (x), through a respective elastic coupling structure (25), which extends centrally, crossing the first horizontal axis (x); each elastic coupling structure (25) defining an elastic lever element (26), of a central-fulcrum type, hinged to the substrate (11) through a central anchorage (27).

6. The gyroscope according to claim 5, in the presence of a pitch angular velocity (Ω_{P}) about the first horizontal axis (x), movement of the detection structure (10;10') is configured to implement an opposite-phase displacement along a vertical axis (z), orthogonal to said horizontal plane (xy), of the pitch detection masses (P1,P2, P1', P2') of each pair and moreover an opposite-phase displacement along the vertical axis (z) of each pitch detection mass (P1,P2) of the first pair and the respective pitch detection mass (P2',P1') of the second pair, due to the rotation of the elastic lever element (26) of the elastic coupling structures (25) about the central anchorage (27), outside of the horizontal plane (xy).

7. The gyroscope according to any of the preceding claims, wherein said pitch detection masses (P1,P2, P1',P2') are arranged externally to said roll detection masses (R1,R2, R1',R2') in the horizontal plane (xy) and are coupled together by respective elastic coupling structures (25), which extend centrally, crossing the first horizontal axis (x) or the second horizontal axis (y), as a whole defining in the horizontal plane (xy) a rectangular frame inside which the driving masses (D1, D2, D1', D2') and the roll-detection masses (R1, R2, R1', R2') are enclosed; each elastic-coupling structure (25) defining an elastic lever element (26), of a central-fulcrum type, hinged to the substrate (11) through a central anchorage (27).

8. The gyroscope according to claim 7, wherein each driving mass (D1, D2) of the first pair is coupled to a respective driving mass (D2', D1') of the second pair, arranged symmetrically with respect to the first horizontal axis (x), by a respective elastic coupling element (18), which extends along the second horizontal axis (y); and wherein each of the driving masses (D1, D2, D1', D2') of the first, respectively second pair, is coupled centrally to the first, respectively second roll-detection mass (R1,R2, R1',R2') by a respective elastic driving element (21).

9. The gyroscope according to claim 7 or 8, wherein said detection structure (10) further comprises a first pair (Y1,Y2) and a second pair (Y1',Y2') of yaw-detection masses, arranged externally to the pitch-detection masses of the first pair (P1, P2) and, respectively, the second pair (P1', P2') in the horizontal plane (xy); wherein each yaw-detection mass (Y1,Y2, Y1',Y2') is elastically coupled to a respective pitch-detection mass (P1, P2, P1', P2') by a respective yaw elastic-coupling element (29); wherein said yaw-detection masses (Y1,Y2, Y1',Y2') have a substantially frame-like conformation, internally defining windows (31) for mobile yaw-detection electrodes (32), alternating with corresponding fixed yaw-detection electrodes (S_{Y}1, S_{Y}2, S_{Y}1', S_{Y}2').

10. The gyroscope according to any of claims 7-9, wherein the first and second roll detection masses (R1,R2, R1',R2') are elastically coupled together by an elastic coupling element (15'), arranged at the first horizontal axis (x).

11. The gyroscope according to any of claims 1-6, wherein said driving masses (D1, D2, D1', D2') are arranged, in the horizontal plane (xy), externally to said pitch-detection masses (P1, P2, P1', P2'); and wherein the driving masses (D1, D2, D1', D2') of each pair are elastically coupled by a respective elastic-coupling structure (37), which defines an elastic lever element with central fulcrum, hinged to the substrate (11) by a central anchorage (38).

12. The gyroscope according to claim 11, wherein said pitch-detection masses (P1, P2, P1', P2') contain within them frames (31') internally defining windows (31) for mobile yaw-detection electrodes (32), which are fixed with respect to the frames and alternate with corresponding fixed yaw detection electrodes (S_{Y}1,S_{Y}2, S_{Y}1',S_{y}2'), designed to detect a yaw angular velocity (Ω_{y}) about a vertical axis (z), orthogonal to said horizontal plane (xy).

13. The gyroscope according to claim 11 or 12, wherein each of the first and second roll-detection masses (R1, R2, R1', R2 ') is surrounded in the horizontal plane (xy) by a respective ring structure (40), which further couples together the pitch-detection masses (P1, P2, P1', P2') of the first, respectively second, pair; and an elastic central element (42), of a torsional type and with a rectangular-frame conformation is arranged at the first horizontal axis (x) and is configured to elastically couple the elastic ring structures (40) associated with the first, respectively second, roll-detection mass (R1,R2, R1',R2').

14. The gyroscope according to claim 13, wherein the pitch-detection masses (P1,P2, P1',P2') of each pair are coupled to the respective ring structure (40) by respective elastic elements (41), at a central portion of the respective ring structure (40); the pitch-detection masses (P1, P2, P1', P2') of the first and second pairs thus being interposed between respective drive masses (D1,D2, D1',D2') of the first and second pairs and the first, respectively second, roll detection mass (R1,R2, R1',R2').

15. the gyroscope according to any of the preceding claims, wherein said first horizontal axis (x) coincides with an axis of pitch detection of the detection structure (10;10'), about which a pitch angular velocity (Ωₚ) is to be detected; said second horizontal axis (y) coincides with a roll-detection axis of the detection structure (10;10'), about which a roll angular velocity (Ωᵣ) is to be detected; and a vertical axis (z), orthogonal to said horizontal plane (xy), coincides with a yaw-detection axis, about which a yaw angular velocity (Ω_{y}) is to be detected.
